# EUROPÄISCHE PATENTANMELDUNG

(11) **EP 3 796 011 A1**
(43) Veröffentlichungstag der Anmeldung: **24.03.2021**
(21) Anmeldenummer: 19198066.3
(22) Anmeldetag: 18.09.2019
(51) Int. Cl.: G01R 31/12

(54) **AUSWERTEN VON TEILENTLADUNGSSIGNALEN**

(71) Anmelder: Siemens Aktiengesellschaft, 80333 München (DE)
(72) Erfinder: Meyer, Martin, 90425 Nürnberg (DE); Scheibner, Dirk, 90473 Nürnberg (DE); Zettner, Jürgen, 90587 Veitsbronn (DE)

(57) **Zusammenfassung**

Die Erfindung betrifft ein Verfahren zum Auswerten von Teilentladungssignalen, die in der Nähe einer Isolierung der elektrischen Außenleiter eines Mehrphasenwechselstroms, dessen in jeweils einem Außenleiter fließende Wechselströme feste Phasenverschiebungen gegeneinander aufweisen, an nur einem Ort erfasst oder an mehreren Orten erfasst und einander überlagert werden. Bei dem Verfahren wird wenigstens eine Kenngröße (K) der Teilentladungssignale definiert, und jedem Teilentladungssignal wird eine Phasenlage der Wechselströme zum Zeitpunkt der Erfassung des Teilentladungssignals zugeordnet. Für jedes Teilentladungssignal wird ein Kenngrößenwert jeder Kenngröße (K) ermittelt, und jedem Teilentladungssignal wird ein Zahlentupel zugeordnet, das aus jedem Kenngrößenwert des Teilentladungssignals und der dem Teilentladungssignal zugeordneten Phasenlage gebildet wird. Es werden Cluster (C) der Teilentladungssignale in einem mehrdimensionalen Raum mit von den Zahlentupeln gebildeten Punkten (V) ermittelt und aus den ermittelten Clustern (C) wird für jeden Außenleiter eine Teilentladungsaktivität ermittelt.

## Beschreibung

Die Erfindung betrifft das Auswerten von Teilentladungssignalen, die in der Nähe einer Isolierung der elektrischen Außenleiter eines Mehrphasenwechselstroms an nur einem Ort erfasst oder an mehreren Orten erfasst und einander überlagert werden. Mit anderen Worten betrifft die Erfindung ein "einkanaliges" Auswerten von Teilentladungssignalen, die nicht getrennt für die einzelnen Außenleitern des Mehrphasenwechselstroms erfasst und ausgewertet werden.

Teilentladungen sind lokale elektrische Entladungen, welche beispielsweise in lokalen Inhomogenitäten des Isolationsmaterials, beispielsweise in kleinen Lufteinschlüssen, innerhalb der Isolierung einer elektrischen Leitung infolge starker Inhomogenitäten eines elektrischen Feldes verursacht werden. Teilentladungen können eine Isolierung lokal beschädigen und langfristig zum Versagen der Isolierung führen. Deshalb werden insbesondere elektrische Maschinen regelmäßig auf Teilentladungen untersucht. Teilentladungen verursachen kurze elektromagnetische Pulse mit einer typischen Pulsdauer von weniger als 1 µs und Frequenzanteilen bis weit in den UHF-Frequenzbereich. Üblicherweise wird nach Teilentladungssignalen in Frequenzbereichen zwischen etwa 100 kHz und 10 MHz gesucht, in denen Teilentladungspulse in der Regel am stärksten sind.

Für die Erfassung von Teilentladungen gibt es eine Vielzahl von teilweise, beispielsweise nach DIN EN 60270, genormten Messverfahren. An elektrischen Maschinen werden fast ausschließlich Offline-Messungen durchgeführt, bei denen der reguläre Betrieb einer elektrischen Maschine unterbrochen wird und hohe Kosten entstehen, beispielsweise durch die Betriebsunterbrechungen und die Kosten für die Messgeräte. Solche Messungen können deshalb nur gelegentlich durchgeführt werden.

Online-Messungen während des regulären Betriebs einer elektrischen Maschine ermöglichen ein kontinuierliches Überwachen der Maschine und insbesondere das Erkennen von Trends bezüglich Teilentladungsaktivitäten an der Maschine und eine Korrelation der Teilentladungsaktivitäten mit verschiedenen Umwelteinflüssen wie Temperatur, Luftfeuchte und Luftdruck. Die dadurch gewonnenen Informationen können eine zuverlässige Vorhersage ermöglichen, die den Zeitraum prognostiziert, in dem eine von Teilentladungen betroffene Maschine noch zuverlässig betrieben werden kann. Durch Messungen erfasste Teilentladungssignale werden typischerweise netzphasensynchron für Intervalle ihrer jeweiligen Energieinhalte als Teilentladungsrate in Form von Teilentladungshistogrammen aufgetragen und ausgewertet.

Im Falle eines aus mehreren Wechselströmen gebildeten Mehrphasenwechselstroms überlagern sich die Teilentladungen zeitlich, die von den verschiedenen Wechselströmen erzeugt werden. Deshalb werden in der Regel Teilentladungssignale für jeden dieser Wechselströme separat erfasst und ausgewertet. Will man aus Gründen der Kostenersparnis nur eine Teilentladungsmesseinheit beziehungsweise nur eine Auswerteeinheit verwenden, das heißt Teilentladungssignale an nur einem Ort erfassen oder an mehreren Orten erfasste, aber einander überlagerte Teilentladungssignale auswerten, so stellt sich das Problem, dass mit der herkömmlichen Auswertung von Teilentladungssignalen keine Aussagen mit Bezug auf die einzelnen Wechselströme möglich sind.

Der Erfindung liegt die Aufgabe zugrunde, ein Verfahren zum verbesserten Auswerten von Teilentladungssignalen anzugeben, die in der Nähe einer Isolierung der elektrischen Außenleiter eines Mehrphasenwechselstroms an nur einem Ort erfasst oder an mehreren Orten erfasst und einander überlagert werden.

Die Aufgabe wird erfindungsgemäß durch ein Verfahren mit den Merkmalen des Anspruchs 1 gelöst.

Vorteilhafte Ausgestaltungen der Erfindung sind Gegenstand der abhängigen Ansprüche.

Bei dem erfindungsgemäßen Verfahren werden Teilentladungssignale ausgewertet, die in der Nähe einer Isolierung der elektrischen Außenleiter eines Mehrphasenwechselstroms, dessen in jeweils einem Außenleiter fließende Wechselströme feste Phasenverschiebungen gegeneinander aufweisen, an nur einem Ort erfasst oder an mehreren Orten erfasst und einander überlagert werden. Dazu wird wenigstens eine Kenngröße definiert, anhand derer Teilentladungssignale miteinander vergleichbar sind. Jedem Teilentladungssignal wird eine Phasenlage der Wechselströme zum Zeitpunkt der Erfassung des Teilentladungssignals zugeordnet. Für jedes Teilentladungssignal wird ein Kenngrößenwert jeder Kenngröße ermittelt. Jedem Teilentladungssignal wird ein Zahlentupel zugeordnet, das aus jedem Kenngrößenwert des Teilentladungssignals und der dem Teilentladungssignal zugeordneten Phasenlage gebildet wird. Es werden dann Cluster der Teilentladungssignale in einem mehrdimensionalen Raum mit von den Zahlentupeln gebildeten Punkten ermittelt, und aus den ermittelten Clustern wird für jeden Außenleiter eine Teilentladungsaktivität ermittelt.

Das erfindungsgemäße Verfahren sieht also die Auswertung von Teilentladungssignalen in einem mehrdimensionalen Raum vor, dessen Koordinaten wenigstens eine Kenngröße der Teilentladungssignale und die Phasenlage der Wechselströme sind. In diesem Raum wird jedes Teilentladungssignal durch einen Punkt repräsentiert, der durch den wenigstens einen Kenngrößenwert des Teilentladungssignals und die Phasenlage zum Zeitpunkt der Erfassung des Teilentladungssignals bestimmt ist. Die die Teilentladungssignale repräsentierenden Punkte werden mit einer Clusteranalyse zu verschiedenen Clustern zusammenfasst, um die Teilentladungssignale den verschiedenen Außenleitern zuzuordnen beziehungsweise für jeden Außenleiter eine Teilentladungsaktivität zu ermitteln. Das erfindungsgemäße Verfahren ermöglicht damit eine phasen- beziehungsweise außenleiterabhängige Auswertung der Teilentladungssignale mit nur einer Messeinheit statt mit einer separaten Messeinheit für jeden Außenleiter und kann daher kostengünstig realisiert werden. Außerdem ermöglicht das erfindungsgemäße Verfahren, Teilentladungssignale online auszuwerten, beispielsweise im regulären Betrieb einer den Mehrphasenwechselstrom führenden elektrischen Maschine, da die Clusteranalyse keine speziellen Betriebsbedingungen erfordert.

Bei einer Ausgestaltung der Erfindung wird eine Pulsdauer, Pulshöhe, elektrische Ladung, Energie und/oder Wiederholungsrate eines Teilentladungssignals als Kenngröße definiert. Beispielsweise bildet die Pulsdauer eine erste Kenngröße, die Pulshöhe bildet eine zweite Kenngröße usw.

Bei einer weiteren Ausgestaltung der Erfindung werden die Cluster mit einem partionierenden Clusterverfahren, einem hierarchischen Clusterverfahren, einem dichtebasierten Clusterverfahren und/oder mit Methoden neuronaler Netze ermittelt. Beispielsweise kann zum Clustering ein k-Means-Algorithmus, Mean Shift, Gaussian Mixture und/oder DBSCAN (density-based spatial clustering of applications with noise) verwendet werden.

Bei einer weiteren Ausgestaltung der Erfindung wird für jedes Cluster ein Clusterschwerpunkt bestimmt und das Cluster wird einem Außenleiter zugeordnet, der aus der Phasenlage des Clusterschwerpunkts bestimmt wird. Beispielsweise wird jeder Phasenlage ein Außenleiter zugeordnet und ein Cluster wird demjenigen Außenleiter zugeordnet, der der Phasenlage des Clusterschwerpunkts des Clusters zugeordnet ist. Insbesondere kann vorgesehen sein, dass jeder Außenleiter wenigstens einem Phasenwinkelintervall von die Phasenlagen charakterisierenden Phasenwinkeln zugeordnet wird. Diese Ausgestaltung der Erfindung nutzt aus, dass Teilentladungen an einem Außenleiter sich in der Regel in bestimmten Phasenwinkelintervallen des in dem Außenleiter fließenden Wechselstroms häufen, beispielsweise in Phasenwinkelintervallen, in denen der Wechselstrom oder die korrespondierende Wechselspannung eine relativ starke Steigung aufweist. Da die Wechselströme der einzelnen Außenleiter feste Phasenverschiebungen gegeneinander aufweisen, können daher Phasenwinkelintervalle von die Phasenlagen der Wechselströme charakterisierenden Phasenwinkeln jeweils einem der Außenleiter zugeordnet werden, an dem in dem jeweiligen Phasenwinkelintervall eine erhöhte Wahrscheinlichkeit für Teilentladungen vorliegt.

Bei einer weiteren Ausgestaltung der Erfindung wird zur Ermittlung der Teilentladungsaktivität eines Außenleiters wenigstens eine Aktivitätsgröße für Teilentladungssignale definiert, die in einem vorgegebenen Zeitfenster erfasst werden und dem Außenleiter zugeordnet werden. Als eine Aktivitätsgröße wird beispielsweise eine Anzahl von Teilentladungssignalen definiert, die in dem Zeitfenster erfasst werden und dem Außenleiter zugeordnet werden. Alternativ oder zusätzlich wird eine Aktivitätsgröße aus den Kenngrößenwerten der Teilentladungssignale gebildet, die in dem Zeitfenster erfasst werden und dem Außenleiter zugeordnet werden. Dies ermöglicht eine quantitative Bewertung und Auswertung der Teilentladungsaktivität an jedem Außenleiter.

Bei einer Weitergestaltung der vorgenannten Ausgestaltung der Erfindung wird eine zeitliche Verteilung der Aktivitätswerte wenigstens einer Aktivitätsgröße jedes Außenleiters erfasst und ausgewertet. Dabei kann vorgesehen sein, dass für jede zeitliche Verteilung von Aktivitätswerten eine Anomalieerkennung durchgeführt wird, mit der anomale Aktivitätswerte ermittelt werden, und anomale Aktivitätswerte aus der jeweiligen Verteilung der Aktivitätswerte entfernt werden. Ferner kann vorgesehen sind, dass für wenigstens eine Aktivitätsgröße und jeden Außenleiter aus der zeitlichen Verteilung der Aktivitätswerte eine Regressionskurve für einen Verlauf der Aktivitätsgröße in Abhängigkeit von der Zeit ermittelt wird. Zusätzlich kann vorgesehen sein, dass eine erste Ableitung jeder Regressionskurve nach der Zeit ermittelt wird. Durch derartige Auswertungen der zeitlichen Verteilungen von Aktivitätswerte der einzelnen Außenleiter können vorteilhaft Trends der Teilentladungsaktivitäten an jedem Außenleiter erkannt werden und Prognosen der zukünftigen Entwicklung dieser Teilentladungsaktivitäten hergeleitet werden. Ferner können beispielsweise Warn- und/oder Alarmsignale erzeugt werden, wenn eine Regressionskurve einen vorgegebenen Schwellenwert überschreitet oder die Ableitung einer Regressionskurve einen vorgegebenen Schwellenwert überschreitet.

Eine erfindungsgemäße Auswerteeinheit zum Auswerten von Teilentladungssignalen gemäß dem erfindungsgemäßen Verfahren ist eingerichtet, jedem Teilentladungssignal die Phasenlage der Wechselströme zum Zeitpunkt der Erfassung des Teilentladungssignals zuzuordnen, für jedes Teilentladungssignal den Kenngrößenwert jeder Kenngröße zu ermitteln, jedem Teilentladungssignal das Zahlentupel zuzuordnen, das aus jedem Kenngrößenwert des Teilentladungssignals und der dem Teilentladungssignal zugeordneten Phasenlage gebildet wird, die Cluster der Teilentladungssignale in dem mehrdimensionalen Raum mit von den Zahlentupeln gebildeten Punkten zu ermitteln und aus den ermittelten Clustern für jeden Außenleiter die Teilentladungsaktivität zu ermitteln.

Insbesondere kann die Auswerteeinheit dazu eingerichtet sein, ein erfindungsgemäßes Computerprogramm auszuführen. Ein erfindungsgemäßes Computerprogramm umfasst Befehle, die bei der Ausführung des Computerprogramms durch eine Auswerteeinheit diese veranlassen, das erfindungsgemäße Verfahren auszuführen.

Dadurch kann das erfindungsgemäße Verfahren mit den oben genannten Vorteilen, insbesondere computerimplementiert, realisiert werden.

Alternativ kann das Verfahren in wenigstens einem so genannten Edge Device oder in einer Applikation in einer Rechnerwolke (Cloud) ausgeführt oder teilausgeführt werden.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
- FIG 1: ein Ablaufdiagramm eines Ausführungsbeispiels eines erfindungsgemäßen Verfahrens zum Auswerten von Teilentladungssignalen,
- FIG 2: Cluster von Teilentladungssignalen und Clusterschwerpunkte,
- FIG 3: eine zeitliche Verteilung von Aktivitätswerten einer Aktivitätsgröße für eine Teilentladungsaktivität und eine Regressionskurve für einen zeitlichen Verlauf der Aktivitätsgröße,
- FIG 4: Regressionskurven für zeitliche Verläufe einer Aktivitätsgröße für die Außenleiter eines Dreiphasenwechselstroms.

Einander entsprechende Teile sind in den Figuren mit denselben Bezugszeichen versehen.

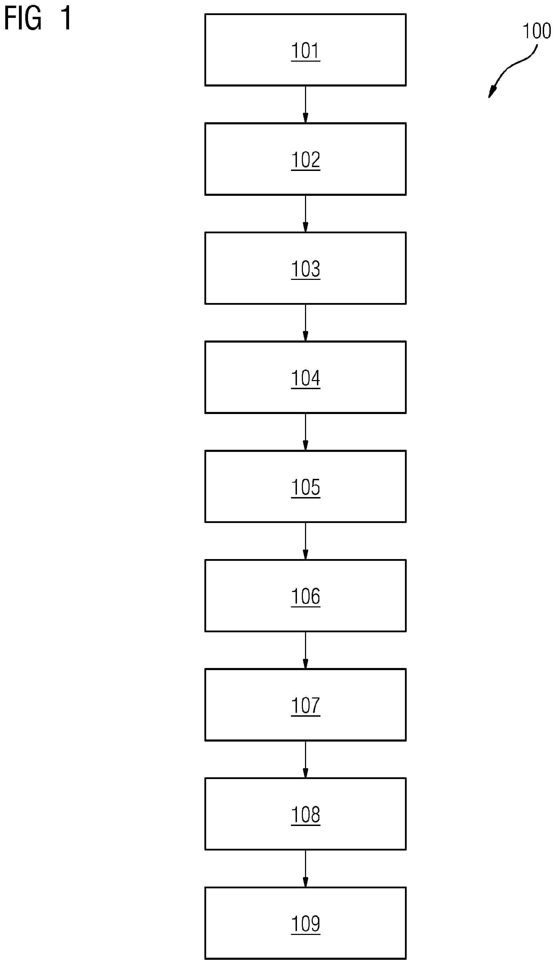

FIG 1 zeigt ein Ablaufdiagramm 100 eines Ausführungsbeispiels eines erfindungsgemäßen Verfahrens mit Verfahrensschritten 101 bis 109 zum Auswerten von Teilentladungssignalen, die in der Nähe einer Isolierung der elektrischen Außenleiter eines Mehrphasenwechselstroms, dessen in jeweils einem Außenleiter fließende Wechselströme feste Phasenverschiebungen gegeneinander aufweisen, an nur einem Ort erfasst oder an mehreren Orten erfasst und einander überlagert werden. Die Teilentladungssignale werden beispielsweise mit einer Antenne erfasst und mit einem Frequenzfilter gefiltert, dessen Durchlassbereich für Teilentladungssignale typische Frequenzen aufweist. Es kann aber auch ein beliebiger anderer Sensor zum Erfassen der Teilentladungssignale verwendet werden, beispielsweise eine kapazitive Sensorvorrichtung mit mindestens einem Sensorkondensator oder eine induktive Kopplungsvorrichtung mit mindestens einer Sensorspule. Dies ist für die Erfindung unerheblich.

In einem ersten Verfahrensschritt 101 wird wenigstens eine Kenngröße K definiert, anhand derer Teilentladungssignale miteinander vergleichbar sind. Eine derartige Kenngröße kann beispielsweise eine Pulsdauer, Pulshöhe, elektrische Ladung, Energie oder Wiederholungsrate eines Teilentladungssignals sein.

In einen zweiten Verfahrensschritt 102 wird jedem Teilentladungssignal eine Phasenlage der Wechselströme zum Zeitpunkt der Erfassung des Teilentladungssignals zugeordnet. Die Phasenlage wird durch einen Phasenwinkel ϕ eines der Wechselströme definiert.

In einem dritten Verfahrensschritt 103 wird für jedes Teilentladungssignal ein Kenngrößenwert jeder Kenngröße K ermittelt.

In einem vierten Verfahrensschritt 104 wird jedem Teilentladungssignal ein Zahlentupel zugeordnet, das aus jedem Kenngrößenwert des Teilentladungssignals und der dem Teilentladungssignal zugeordneten Phasenlage gebildet wird. Wenn beispielsweise die Kenngrößen K eine Pulsdauer und Pulshöhe sind, sind die Einträge des einem Teilentladungssignal zugeordneten Zahlentupels der Kenngrößenwert der Pulsdauer, der Kenngrößenwert der Pulshöhe und die dem Teilentladungssignal zugeordnete Phasenlage.

In einem fünften Verfahrensschritt 105 werden jeweils für ein vorgegebenes Zeitfenster Cluster C der in diesem Zeitfenster erfassten Teilentladungssignale in einem mehrdimensionalen Raum S mit von den Zahlentupeln gebildeten Punkten V ermittelt. Die Cluster C werden beispielsweise mit einem partionierenden Clusterverfahren (z.B. basierend auf einem k-Means-Algorithmus), einem hierarchischen Clusterverfahren, einem dichtebasierten Clusterverfahren (z.B. DBSCAN) und/oder mit Methoden neuronaler Netze ermittelt.

In einem sechsten Verfahrensschritt 106 wird jedem Cluster C ein Außenleiter zugeordnet. Dazu wird jeder Außenleiter wenigstens einem Phasenwinkelintervall I1 bis I6 zugeordnet, für jedes Cluster C wird ein Clusterschwerpunkt P bestimmt und ein Cluster C wird demjenigen Außenleiter zugeordnet, der der Phasenlage des Clusterschwerpunkts P des Clusters C (das heißt dem Wert der Koordinate ϕ des Clusterschwerpunkts P in dem Raum S) zugeordnet ist.

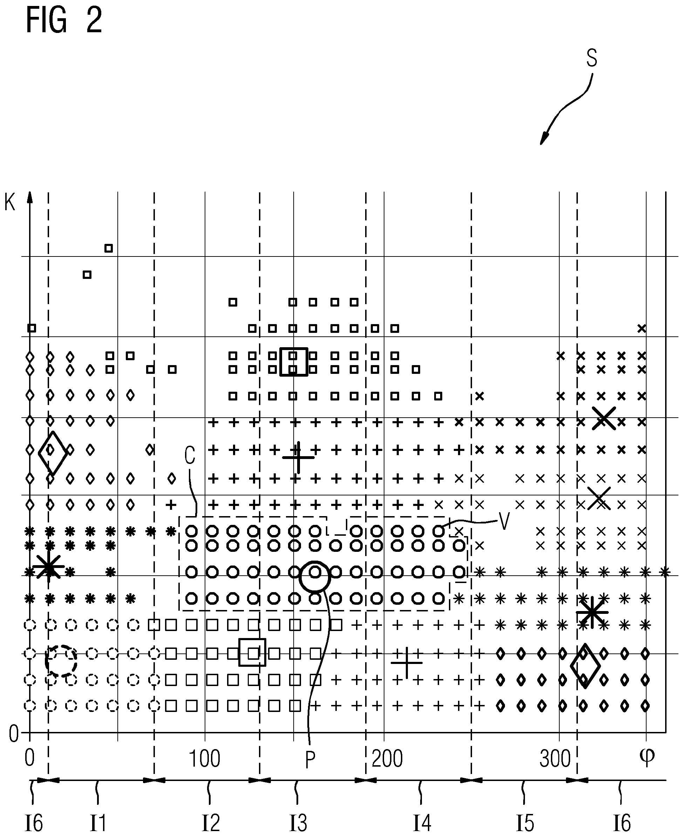

FIG 2 zeigt beispielhaft für einen Dreiphasenwechselstrom mit um 120° gegeneinander phasenverschobenen Wechselströmen in einem Zeitfenster ermittelte Cluster C und deren Clusterschwerpunkte P, wobei die einem Cluster C zugehörigen Punkte V durch gleiche und von anderen Clustern C verschiedene Symbole dargestellt sind. Einem ersten Außenleiter sind die Phasenwinkelintervalle I1 und I4 zugeordnet. Einem zweiten Außenleiter sind die Phasenwinkelintervalle I2 und I5 zugeordnet. Dem dritten Außenleiter sind die Phasenwinkelintervalle I3 und I6 zugeordnet. Jedes Phasenwinkelintervall I1 bis I6 hat eine Breite von 60°. Die Phasenwinkelintervalle I1 und I3 weisen jeweils drei Clusterschwerpunkte P auf. Die Phasenwinkelintervall I2 und I4 weisen jeweils einen Clusterschwerpunkt P auf. Das Phasenwinkelintervall I5 weist keinen Clusterschwerpunkt P auf. Das Phasenwinkelintervall I6 weist vier Clusterschwerpunkte P auf. Somit werden dem ersten Außenleiter in dem Zeitfenster insgesamt vier Clusterschwerpunkte P zugeordnet, dem zweiten Außenleiter wird ein Clusterschwerpunkt P zugeordnet, und dem dritten Außenleiter werden sieben Clusterschwerpunkte P zugeordnet.

In einem siebten Verfahrensschritt 107 wird aus den ermittelten Clustern C für jeden Außenleiter eine Teilentladungsaktivität in jedem Zeitfenster ermittelt. Dazu wird wenigstens eine Aktivitätsgröße A für Teilentladungssignale definiert, die in dem jeweiligen Zeitfenster erfasst werden und einem Außenleiter zugeordnet werden. Als eine Aktivitätsgröße A wird beispielsweise eine Anzahl von Teilentladungssignalen definiert, die in dem Zeitfenster erfasst werden und dem Außenleiter zugeordnet werden. Alternativ oder zusätzlich wird eine Aktivitätsgröße A aus den Kenngrößenwerten der Teilentladungssignale gebildet, die in dem Zeitfenster erfasst werden und dem Außenleiter zugeordnet werden. Beispielsweise wird als eine Aktivitätsgröße A der Wert einer Kenngröße K des Clusterschwerpunkts P verwendet, und/oder eine Aktivitätsgröße A wird aus Maxima, Minima, Standardabweichungen, Verhältnissen von Maxima zu Mittelwerten und/oder statistischen Momenten der Kenngrößenwerte der zu einem Cluster C gehörigen Teilentladungssignale gebildet.

In einem achten Verfahrensschritt 108 wird eine zeitliche Verteilung der Aktivitätswerte wenigstens einer Aktivitätsgröße A jedes Außenleiters erfasst, beispielsweise eine Verteilung über mehrere Monate. Ferner wird für jede dieser zeitlichen Verteilungen eine Anomalieerkennung (engl. anomaly detection, auch als outlier detection bezeichnet) durchgeführt, mit der so genannte anomale Aktivitätswerte ermittelt werden, und anomale Aktivitätswerte werden aus der jeweiligen Verteilung der Aktivitätswerte entfernt. Zur Anomalieerkennung wird eine zeitliche Verteilung der Aktivitätswerte beispielsweise mit einem dichtebasierten Clusterverfahren wie DBSCAN analysiert. Eine derartige Anomalieerkennung ist beispielsweise aus M. M. Breunig et al., LOF: identifying density-based local outliers, Proceedings of the 2000 ACM SIGMOD international conference on Management of data, S. 93-104, doi: 10.1145/342009.335388 bekannt.

In einem neunten Verfahrensschritt 109 wird für wenigstens eine Aktivitätsgröße A und jeden Außenleiter aus der zeitlichen Verteilung der Aktivitätswerte eine Regressionskurve R, R1 bis R3 für einen Verlauf der Aktivitätsgröße A in Abhängigkeit von der Zeit t ermittelt, beispielsweise mit bekannten Methoden der so genannten Support Vector Machine Regression. Ferner kann vorgesehen sein, eine erste Ableitung jeder Regressionskurve R, R1 bis R3 nach der Zeit zu ermitteln. Anhand der Regressionskurven R, R1 bis R3 sowie gegebenenfalls deren erster Ableitungen wird die zeitliche Entwicklung der Teilentladungsaktivitäten jedes Außenleiters überwacht. Beispielsweise wird automatisch ein Warn- und/oder Alarmsignal erzeugt, wenn eine Regressionskurve R, R1 bis R3 einen vorgegebenen Schwellenwert oder die erste Ableitung einer Regressionskurve R, R1 bis R3 einen vorgegebenen Schwellenwert überschreitet.

Das anhand der Verfahrensschritte 101 bis 109 beschriebene Verfahren kann beispielsweise dahingehend erweitert werden, dass vor der Ermittlung der Cluster C in dem vierten Verfahrensschritt 104 eine Anomalieerkennung in dem mehrdimensionalen Raum S durchgeführt wird, um anomale Teilentladungssignale zu eliminieren.

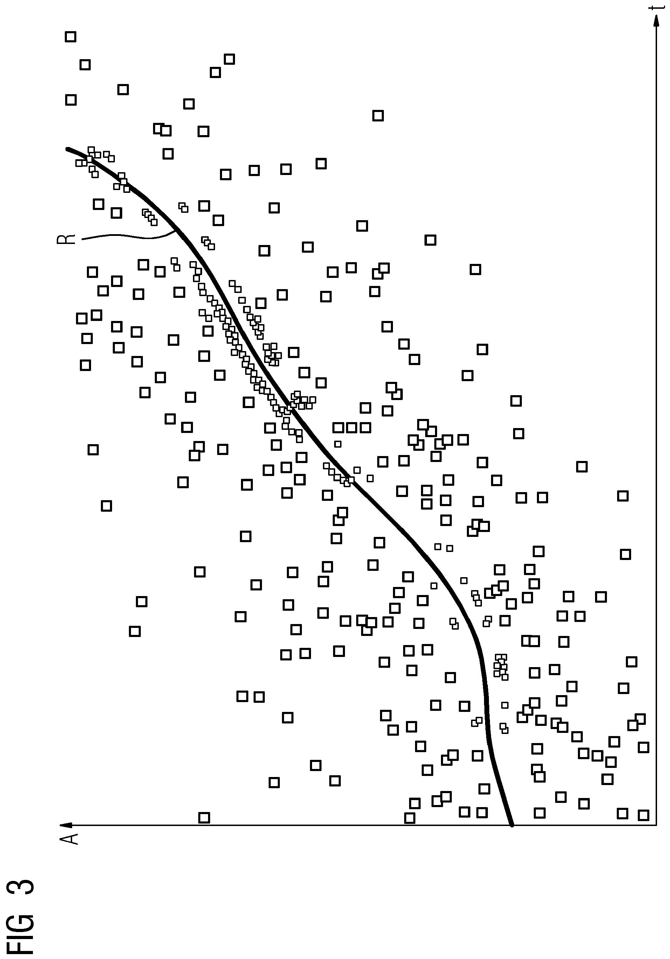

FIG 3 zeigt beispielhaft eine zeitliche Verteilung von Aktivitätswerten einer Aktivitätsgröße A für einen Außenleiter und eine Regressionskurve R für den Verlauf der Aktivitätsgröße A in Abhängigkeit von der Zeit t. Anomale Aktivitätswerte liegen weiter von der Regressionskurve R entfernt und sind mit einem anderen Symbol dargestellt als die anderen Aktivitätswerte A.

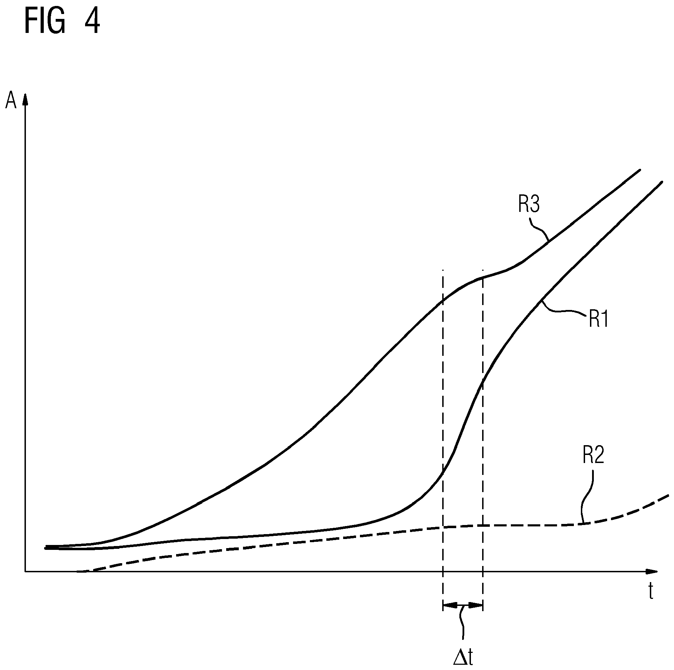

FIG 4 zeigt beispielhaft Regressionskurven R1 bis R3 für zeitliche Verläufe einer Aktivitätsgröße A für die drei Außenleiter eines Dreiphasenwechselstroms. Die Regressionskurve R1 eines ersten Außenleiters verläuft oberhalb der Regressionskurve R2 eines zweiten Außenleiters und unterhalb der Regressionskurve R3 des dritten Außenleiters, weist jedoch in einem Zeitintervall Δt hohe Steigungen auf. Daraus wird beispielsweise gefolgert, dass an dem dritten Außenleiter die höchste Teilentladungsaktivität auftritt, an dem zweiten Außenleiter die geringste Teilentladungsaktivität auftritt und die Teilentladungsaktivität an dem ersten Außenleiter in dem Zeitintervall Δt sehr schnell zunimmt.

Die Verfahrensschritte 101 bis 109 werden beispielsweise durch eine Auswerteeinheit zum Auswerten von Teilentladungssignalen durchgeführt, auf der ein Computerprogramm ausgeführt wird, das Befehle umfasst, die bei der Ausführung des Computerprogramms durch die Auswerteeinheit diese veranlassen, die Verfahrensschritte 101 bis 109 auszuführen. Insbesondere kann die Auswerteeinheit wenigstens einen so genannten neuromorphen integrierten Schaltkreis aufweisen. Alternativ wird das Verfahren in wenigstens einem so genannten Edge Device oder in einer Applikation in einer Rechnerwolke (Cloud) ausgeführt oder teilausgeführt.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Verfahren zum Auswerten von Teilentladungssignalen, die in der Nähe einer Isolierung der elektrischen Außenleiter eines Mehrphasenwechselstroms, dessen in jeweils einem Außenleiter fließende Wechselströme feste Phasenverschiebungen gegeneinander aufweisen, an nur einem Ort erfasst oder an mehreren Orten erfasst und einander überlagert werden, wobei
- wenigstens eine Kenngröße (K) definiert wird, anhand derer Teilentladungssignale miteinander vergleichbar sind,
- jedem Teilentladungssignal eine Phasenlage der Wechselströme zum Zeitpunkt der Erfassung des Teilentladungssignals zugeordnet wird,
- für jedes Teilentladungssignal ein Kenngrößenwert jeder Kenngröße (K) ermittelt wird,
- jedem Teilentladungssignal ein Zahlentupel zugeordnet wird, das aus jedem Kenngrößenwert des Teilentladungssignals und der dem Teilentladungssignal zugeordneten Phasenlage gebildet wird,
- Cluster (C) der Teilentladungssignale in einem mehrdimensionalen Raum (S) mit von den Zahlentupeln gebildeten Punkten (V) ermittelt werden und
- aus den ermittelten Clustern (C) für jeden Außenleiter eine Teilentladungsaktivität ermittelt wird.

2. Verfahren nach Anspruch 1, wobei eine Pulsdauer, Pulshöhe, elektrische Ladung, Energie und/oder Wiederholungsrate eines Teilentladungssignals als Kenngröße (K) definiert wird.

3. Verfahren nach Anspruch 1 oder 2, wobei die Cluster (C) mit einem partionierenden Clusterverfahren, einem hierarchischen Clusterverfahren, einem dichtebasierten Clusterverfahren und/oder mit Methoden neuronaler Netze ermittelt werden.

4. Verfahren nach einem der vorhergehenden Ansprüche, wobei für jedes Cluster (C) ein Clusterschwerpunkt (P) bestimmt wird und das Cluster (C) einem Außenleiter zugeordnet wird, der aus der Phasenlage des Clusterschwerpunkts (P) bestimmt wird.

5. Verfahren nach Anspruch 4, wobei jeder Phasenlage ein Außenleiter zugeordnet wird und ein Cluster (C) demjenigen Außenleiter zugeordnet wird, der der Phasenlage des Clusterschwerpunkts (P) des Clusters (C) zugeordnet ist.

6. Verfahren nach Anspruch 5, wobei jeder Außenleiter wenigstens einem Phasenwinkelintervall (I1 bis I6) von die Phasenlagen charakterisierenden Phasenwinkeln (ϕ) zugeordnet wird.

7. Verfahren nach einem der vorhergehenden Ansprüche, wobei zur Ermittlung der Teilentladungsaktivität eines Außenleiters wenigstens eine Aktivitätsgröße (A) für Teilentladungssignale definiert wird, die in einem vorgegebenen Zeitfenster erfasst werden und dem Außenleiter zugeordnet werden.

8. Verfahren nach Anspruch 7, wobei als eine Aktivitätsgröße (A) eine Anzahl von Teilentladungssignalen definiert wird, die in dem Zeitfenster erfasst werden und dem Außenleiter zugeordnet werden.

9. Verfahren nach Anspruch 7 oder 8, wobei eine Aktivitätsgröße (A) aus den Kenngrößenwerten der Teilentladungssignale gebildet wird, die in dem Zeitfenster erfasst werden und dem Außenleiter zugeordnet werden.

10. Verfahren nach einem der Ansprüche 7 bis 9, wobei eine zeitliche Verteilung der Aktivitätswerte wenigstens einer Aktivitätsgröße (A) jedes Außenleiters erfasst und ausgewertet wird.

11. Verfahren nach Anspruch 10, wobei für jede zeitliche Verteilung von Aktivitätswerten eine Anomalieerkennung durchgeführt wird, mit der anomale Aktivitätswerte ermittelt werden, und anomale Aktivitätswerte aus der jeweiligen Verteilung der Aktivitätswerte entfernt werden.

12. Verfahren nach Anspruch 10 oder 11, wobei für wenigstens eine Aktivitätsgröße (A) und jeden Außenleiter aus der zeitlichen Verteilung der Aktivitätswerte eine Regressionskurve (R, R1, bis R3) für einen Verlauf der Aktivitätsgröße (A) in Abhängigkeit von der Zeit (t) ermittelt wird.

13. Verfahren nach Anspruch 12, wobei eine erste Ableitung jeder Regressionskurve (R, R1, bis R3) nach der Zeit (t) ermittelt wird.

14. Auswerteeinheit zum Auswerten von Teilentladungssignalen gemäß dem Verfahren nach einem der vorhergehenden Ansprüche, wobei die Auswerteeinheit eingerichtet ist,
- jedem Teilentladungssignal die Phasenlage der Wechselströme zum Zeitpunkt der Erfassung des Teilentladungssignals zuzuordnen,
- für jedes Teilentladungssignal den Kenngrößenwert jeder Kenngröße (K) zu ermitteln,
- jedem Teilentladungssignal das Zahlentupel zuzuordnen, das aus jedem Kenngrößenwert des Teilentladungssignals und der dem Teilentladungssignal zugeordneten Phasenlage gebildet wird,
- die Cluster (C) der Teilentladungssignale in dem mehrdimensionalen Raum (S) mit von den Zahlentupeln gebildeten Punkten (V) zu ermitteln und
- aus den ermittelten Clustern (C) für jeden Außenleiter die Teilentladungsaktivität zu ermitteln.

15. Computerprogramm, umfassend Befehle, die bei der Ausführung des Computerprogramms durch eine Auswerteeinheit diese veranlassen, das Verfahren nach einem der Ansprüche 1 bis 13 auszuführen.
